# EUROPEAN PATENT APPLICATION

(11) **EP 4 415 501 A1**
(43) Date of publication of application: **14.08.2024**
(21) Application number: 24156618.1
(22) Date of filing: 08.02.2024
(51) Int. Cl.: H10K 50/828, H10K 59/80, H10K 50/844, H10K 59/40

(54) **DISPLAY DEVICE**

(30) Priority: 13.02.2023 KR 20230018860
(71) Applicant: Samsung Display Co., Ltd., Yongin-si, Gyeonggi-do 17113 (KR)
(72) Inventor: KIM, Jaeik, 17113 Yongin-si (KR); GWARK, Hyejin, 17113 Yongin-si (KR); KIM, Hwi, 17113 Yongin-si (KR); PARK, Jungsun, 17113 Yongin-si (KR); SONG, Seungyong, 17113 Yongin-si (KR); LEE, Duckjung, 17113 Yongin-si (KR); LEE, Yeonhwa, 17113 Yongin-si (KR); LEE, Joongu, 17113 Yongin-si (KR)
(74) Representative: Marks & Clerk LLP

(57) **Abstract**

A display device includes a substrate, a pixel electrode disposed on the substrate, a common layer (212d) disposed on the pixel electrode, and a counter electrode (213) disposed on the common layer, wherein a film density of the common layer is in a range of about 3 g/cm³ to about 10 g/cm³.

## Description

### BACKGROUND

### 1. Technical Field

One or more embodiments relate to a display device.

### 2. Description of the Related Art

Display devices visually display image data. Such display devices include a substrate including a display area and a peripheral area. The display area is provided with a scan line and a data line that are insulated from each other, and includes pixels. The display area includes a thin-film transistor corresponding to each of the pixels and a sub-pixel electrode electrically connected to the thin-film transistor. The display area includes counter electrodes commonly included in the pixels. The peripheral area includes various wiring that transmits electrical signals to the display area, a scan driver, a data driver, a controller, and a pad unit.

The usage of display devices has diversified. Accordingly, various designs have been researched to improve the quality of the display device.

### SUMMARY

One or more embodiments provide a display device capable of improving reliability and touch screen panel characteristics.

However, embodiments of the disclosure are not limited to those set forth herein. The above and other embodiments will become more apparent to one of ordinary skill in the art to which the disclosure pertains by referencing the detailed description of the disclosure given below.

According to one or more embodiments, a display device includes a substrate, a pixel electrode disposed on the substrate, a common layer disposed on the pixel electrode, and a counter electrode disposed on the common layer, wherein a film density of the common layer is in a range of about 3 g/cm³ to about 10 g/cm³.

According to one or more embodiments, the common layer may include ytterbium (Yb).

According to one or more embodiments, the common layer may include a Yb-oxygen (O) bond.

According to one or more embodiments, the counter electrode may include a silver (Ag)-based alloy or an aluminium (Al)-based alloy.

According to one or more embodiments, the Ag-based alloy or the Al-based alloy of the counter electrode may be formed of Ag or Al ranging from about 95% to about 100%.

According to one or more embodiments, the counter electrode may include at least one selected from gold (Au), copper (Cu), magnesium (Mg), titanium (Ti), indium (In), nickel (Ni), carbon (C), palladium (Pd), fluorine (F), sodium (Na), silicon (Si), calcium (Ca), manganese (Mn), iron (Fe), cobalt (Co), zinc (Zn), gallium (Ga), germanium (Ge), molybdenum (Mo), tin (Sn), platinum (Pt), lead (Pb), ytterbium (Yb), lutetium (Lu), and protactinium (Pa).

According to one or more embodiments, the counter electrode may include oxygen (O).

According to one or more embodiments, a thickness of the counter electrode may be in a range of about 5 nm to about 100 nm.

According to one or more embodiments, a resistance of the counter electrode may be in a range of about 1 ohm/sq to about 20 ohm/sq.

According to one or more embodiments, the display device may further include a first functional layer disposed on the pixel electrode, an emission layer disposed on the first functional layer, and a second functional layer disposed on the emission layer.

According to one or more embodiments, the display device may further include a first mixed layer disposed between the second functional layer and the common layer.

According to one or more embodiments, the display device may further include a second mixed layer disposed between the common layer and the counter electrode.

According to one or more embodiments, the display device may further include a first buffer layer disposed under the common layer.

According to one or more embodiments, the first buffer layer may include metal oxide or metal halide.

According to one or more embodiments, the display device may further include a second buffer layer disposed on the counter electrode.

According to one or more embodiments, the second buffer layer may include metal oxide or metal halide.

According to one or more embodiments, the display device may further include a thin-film encapsulation layer disposed over the counter electrode and including a first inorganic encapsulation layer and a second inorganic encapsulation layer disposed on the first inorganic encapsulation layer, and a touch sensor layer disposed on the thin-film encapsulation layer and including touch insulating layers and conductive layers.

According to one or more embodiments, the thin-film encapsulation layer may include an organic encapsulation layer disposed between the first inorganic encapsulation layer and the second inorganic encapsulation layer.

According to one or more embodiments, the display device may further include a first organic insulating layer disposed between the substrate and the pixel electrode.

According to one or more embodiments, the display device may further include a second organic insulating layer disposed between the substrate and the first organic insulating layer.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIGS. 1A and 1B are schematic perspective views of a display device according to an embodiment;
FIGS. 2A and 2B are schematic diagrams of equivalent circuits of a light-emitting diode corresponding to a representative sub-pixel of the display device and a sub-pixel circuit electrically connected to the light-emitting diode;
FIG. 3 is a schematic cross-sectional view of a display panel according to an embodiment;
FIGS. 4A, 4B, and 4C are schematic cross-sectional views of a display panel according to embodiments;
FIG. 5 is a schematic cross-sectional view of an enlarged portion of a display panel according to an embodiment;
FIG. 6 is a schematic graph showing results of X-ray reflectometry (XRR) analysis of a common layer according to a processing method; and
FIG. 7 is a schematic graph showing resistances according to the thickness of each material of a counter electrode.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

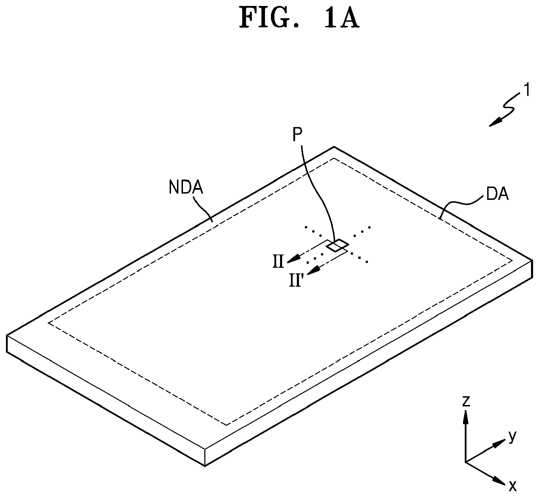

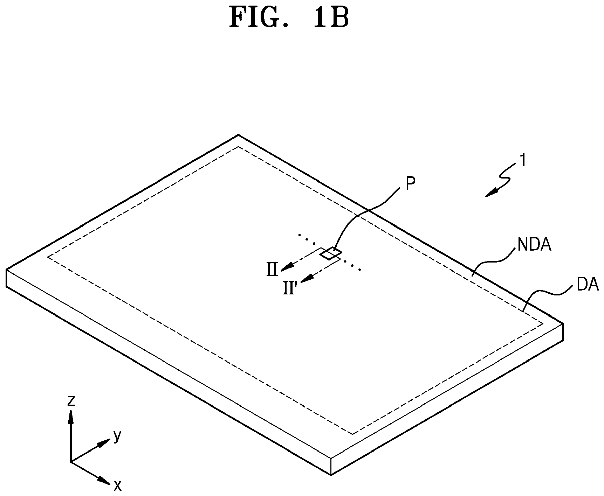

FIGS. 1A and 1B are schematic perspective views of a display device according to an embodiment.

Referring to FIGS. 1A and 1B, a display device 1 may include a display area DA and a non-display area NDA outside the display area DA. The display area DA may display an image through sub-pixels P arranged in the display area DA. The non-display area NDA, which is arranged outside the display area DA, is a non-display area that does not display an image, and may surround (e.g., entirely surround) the display area DA. A driver or the like for providing an electrical signal or power to the display area DA may be arranged in the non-display area NDA. A pad may provide an area to which an electronic element or a printed circuit board is electrically connected. The pad may be arranged in the non-display area NDA.

In an embodiment, FIG. 1A shows the display area DA being a polygon (e.g., a rectangle) of which the length in an x-axis direction is less than the length in a y-axis direction. In another embodiment, FIG. 1B shows the display area DA being a polygon (e.g., a rectangle) of which the length in the y-axis direction is less than the length in the x-axis direction. FIGS. 1A and 1B show that the display area DA is approximately rectangular, but embodiments are not limited thereto. In some embodiments, the display area DA may have various shapes such as an n-sided polygon shape, where n is a natural number greater than or equal to 3, a circular shape, or an elliptical shape. FIGS. 1A and 1B show that the display area DA has a corner portion in a form including a vertex at which two straight lines meet each other, but another embodiment may include a polygon having a round corner portion as the display area DA.

Hereinafter, for convenience of description, a case where the electronic device 1 is a smart phone will be described below, but the electronic device 1 is not limited thereto. The display device 1 may be applied to various products such as televisions, notebook computers, monitors, billboards, and Internet of Things (IoT), as well as portable electronic apparatuses such as mobile phones, smart phones, tablet personal computers (PCs), mobile communication terminals, electronic notebooks, electronic books, portable multimedia players (PMPs), navigation, and Ultra Mobile PCs (UMPCs). For example, the display device 1 according to an embodiment may be used in wearable devices, such as smart watches, watch phones, glasses-type displays, and head-mounted displays (HMDs). Also, the display device 1 according to an embodiment may be applied to a center information display (CID) positioned on a vehicle's instrument panel, center fascia, or dashboard, a room mirror display replacing a vehicle's side mirror, or a display screen positioned at the rear side of a vehicle's front seat as entertainment for a passenger in a vehicle's rear seat.

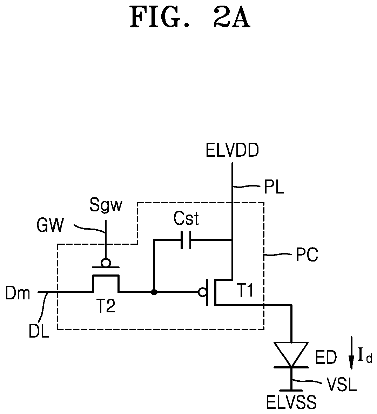

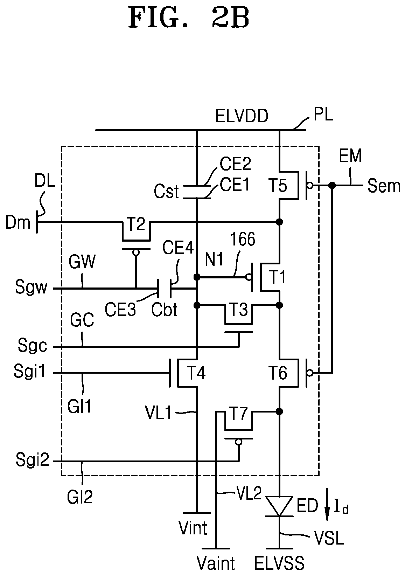

FIGS. 2A and 2B are schematic drawings of equivalent circuits of a light-emitting diode corresponding to a representative sub-pixel of the display device and a sub-pixel circuit electrically connected to the light-emitting diode.

Referring to FIG. 2A, a light-emitting diode ED may be electrically connected to a sub-pixel circuit PC, and the sub-pixel circuit PC may include a first transistor T1, a second transistor T2, and a storage capacitor Cst. A sub-pixel electrode (e.g., an anode) of the light-emitting diode ED may be electrically connected to the first transistor T1, and a counter electrode (e.g., a cathode) may be electrically connected to an auxiliary wiring VSL and may receive a voltage corresponding to a common voltage ELVSS through the auxiliary wiring VSL.

The second transistor T2 may transmit a data signal Dm input through a data line DL to the first transistor T1 according to a scan signal Sgw input through the scan line GW.

The storage capacitor Cst may be connected to the second transistor T2 and a driving voltage line PL and may store a voltage corresponding to a difference between a voltage received from the second transistor T2 and a driving voltage ELVDD supplied to the driving voltage line PL.

The first transistor T1 may be connected to the driving voltage line PL and the storage capacitor Cst and may control a driving current Id flowing from the driving voltage line PL to the light-emitting diode ED in response to a voltage value stored in the storage capacitor Cst. The light-emitting diode ED may emit light having certain brightness according to the driving current Id.

Although a case in which the sub-pixel circuit PC includes two transistors and one storage thin-film transistor has been described with reference to FIG. 2A, embodiments are not limited thereto.

FIG. 2B is a schematic drawing of an equivalent circuit of a light-emitting diode corresponding to a representative sub-pixel of the display device and a sub-pixel circuit electrically connected to the light-emitting diode.

Referring to FIG. 2B, the sub-pixel circuit PC may include seven transistors and two capacitors.

The sub-pixel circuit PC may include first, second, third, fourth, fifth, sixth, and seventh transistors T1, T2, T3, T4, T5, T6, and T7, the storage capacitor Cst, and a boost capacitor Cbt. In another example, the sub-pixel circuit PC may not include the boost capacitor Cbt. The sub-pixel electrode (e.g., the anode) of the light-emitting diode ED may be electrically connected to the first transistor T1 via a sixth transistor T6, and the counter electrode (e.g., the cathode) may be electrically connected to the auxiliary wiring VSL and may receive a voltage corresponding to the common voltage ELVSS through the auxiliary wiring VSL.

Some of the first to seventh transistors T1, T2, T3, T4, T6, T6, and T7 may be n-channel metal oxide semiconductor field effect transistors (MOSFET) (NMOS), and the others may be p-channel MOSFETs (PMOS). In an embodiment, as shown in FIG. 2B, the third and fourth transistors T3 and T4 may be NMOS, and the others may be PMOS. For example, the third and fourth transistors T3 and T4 may be NMOS including oxide-based semiconductor materials, and the others may be PMOS including silicon-based semiconductor materials. In other examples, the third, fourth, and seventh transistors T3, T4, and T7 may be NMOS, and the others may be PMOS.

The first to seven transistors T1, T2, T2, T3, T4, T6, and T7, the storage capacitor Cst, and the boost capacitor Cbt may be connected to a signal line. The signal line may include a scan line GW, an emission control line EM, a compensation gate line GC, first initializing gate line GI1, a second initializing gate line GI2, and data line DL. The sub-pixel circuit PC may be electrically connected to a voltage line, such as the driving voltage line PL, a first initializing voltage line VL1, and a second initializing voltage line VL2.

The first transistor T1 may include a driving transistor. A first gate electrode of the first transistor T1 may be connected to the storage capacitor Cst, a first electrode of the first transistor T1 may be electrically connected to the driving voltage line PL via the fifth transistor T5, and a second electrode of the first transistor T1 may be electrically connected to a first electrode (e.g., an anode) of the light-emitting diode ED via the sixth transistor T6. One of the first and second electrodes of the first transistor T1 may be a source electrode and the other may be a drain electrode. The first transistor T1 may supply the driving current Id to the light-emitting diode ED according to a switching operation of the second transistor T2.

The second transistor T2 may include a switching transistor. A second gate electrode of the second transistor T2 may be connected to the scan line GW, a first electrode of the second transistor T2 may be connected to the data line DL, a second electrode of the second transistor T2 may be connected to a driving first electrode of the first transistor T1 and may be electrically connected to the driving voltage line PL via the fifth transistor T5. One of the first and second electrodes of the second transistor T2 may be a source electrode and the other may be a drain electrode. The second transistor T2 may be turned on according to the scan signal Sgw received through the scan line GW to perform a switching operation of transmitting the data signal Dm received through the data line DL to the first electrode of the first transistor T1.

The third transistor T3 may be a compensation transistor for compensating a threshold voltage of the first transistor T1. A third gate electrode of the third transistor T3 may be connected to the compensation gate line GC. A first electrode of the third transistor T3 may be connected to a lower electrode CE1 of the storage capacitor Cst and the first gate electrode of the first transistor T1 via a node connection line 166. The first electrode of the third transistor T3 may be connected to the fourth transistor T4. A second electrode of the third transistor T3 may be connected to the second electrode of the first transistor T1 and may be electrically connected to the first electrode (e.g., the anode) of the light-emitting diode ED via the sixth transistor. One of the first and second electrodes of the third transistor T3 may be a source electrode and the other may be a drain electrode.

The third transistor T3 may be turned on according to a compensation signal Sgc received through the compensation gate line GC to electrically connect the first gate electrode of the first transistor T1 and the second electrode (e.g., the drain electrode) of the first transistor T1 to each other to diode-connect the first transistor T1.

The fourth transistor T4 may be a first initializing transistor that initializes the first gate electrode of the first transistor T1. A fourth gate electrode of the fourth transistor T4 may be connected to the first initializing gate line GI1. The first electrode of the fourth transistor T4 may be connected to the first initializing voltage line VL1. A second electrode of the fourth transistor T4 may be connected to the lower electrode CE1 of the storage capacitor Cst, the first electrode of the third transistor T3, and the first gate electrode of the first transistor T1. One of the first and second electrodes of the fourth transistor T4 may be a source electrode and the other may be a drain electrode. The fourth transistor T4 may be turned on according to a first initializing signal Sgi1 received through the first initializing gate line GI1 to perform an initialization operation of initializing the voltage of the first gate electrode of the first transistor T1 by transmitting a first initializing voltage Vint to the first gate electrode of the first transistor T1.

The fifth transistor T5 may include an operation control transistor. A fifth gate electrode of the fifth transistor T5 may be connected to the emission control line EM, a first electrode of the fifth transistor T5 may be connected to the driving voltage line PL, and a second electrode of the fifth transistor T5 may be connected to the driving first electrode of the first transistor T1 and the second electrode of the second transistor T2. One of the first and second electrodes of the fifth transistor T5 may be a source electrode and the other may be a drain electrode.

The sixth transistor T6 may include an emission control transistor. A sixth gate electrode of the sixth transistor T6 may be connected to the emission control line EM, a first electrode of the sixth transistor T6 may be connected to the second electrode of the first transistor T1 and the second electrode of the third transistor T3, and a second electrode of the sixth transistor T6 may be electrically connected to a second electrode of the seventh transistor T7 and the first electrode (e.g., the anode) of the light-emitting diode ED. One of the first and second electrodes of the sixth transistor T6 may be a source electrode and the other may be a drain electrode.

The fifth transistor T5 and the sixth transistor T6 may be simultaneously turned on according to an emission control signal Sem received through the emission control line EM, and thus, a driving voltage ELVDD may be applied to the light-emitting diode ED, and a driving current Id flows in the light-emitting diode ED.

The seventh transistor T7 may include a second initializing transistor that initializes the first electrode (e.g., the anode) of the light-emitting diode ED. A seventh gate electrode of the seventh transistor T7 may be connected to the second initializing gate line GI2. A first electrode of the seventh transistor T7 may be connected to the second initializing voltage line VL2. The second electrode of the seventh transistor T7 may be connected to the second electrode of the sixth transistor T6 and the first electrode (e.g., the anode) of the light-emitting diode ED. The seventh transistor T7 may be turned on according to a second initializing signal Sgi2 received through the second initializing gate line GI2 to apply the second initializing voltage Vaint to the first electrode (e.g., the anode) of the light-emitting diode ED to initialize the first electrode of the light-emitting diode ED.

In some embodiments, the second initializing voltage line VL2 may be a scan line. For example, the second initializing gate line GI2 connected to the seventh transistor T7 of the sub-pixel circuit PC of the i-th row, where i is a natural number, may correspond to the scan line of the sub-pixel circuit PC of the (i+1)-th row. In another example, the second initializing voltage line VL2 may be an emission control line EM. For example, the emission control line EM may be electrically connected to the fifth to seventh transistors T5, T6, and T7.

The storage capacitor Cst may include the lower electrode CE1 and an upper electrode CE2. The lower electrode CE1 of the storage capacitor CST may be connected to the first gate electrode of the first transistor T1, and the upper electrode CE2 of the storage capacitor Cst may be connected to the driving voltage line PL. The storage capacitor Cst may store charges corresponding to a difference between a voltage of the first gate electrode of the first transistor T1 and the driving voltage ELVDD.

The boost capacitor Cbt may include a third electrode CE3 and a fourth electrode CE4. The third electrode CE3 may be connected to the second gate electrode of the second transistor T2 and the scan line GW, and the fourth electrode CE4 may be connected to the first electrode of the third transistor T3 and the node connection line 166. The boost capacitor Cbt may increase the voltage of a first node N1 in the case that the scan signal Sgw supplied to the scan line GW is turned-off, and the black grayscale may be expressed clearly in the case that the voltage of the first node N1 is increased.

The first node N1 may be an area to which the first gate electrode of the first transistor T1, the first electrode of the third transistor T3, the second electrode of the fourth transistor T4, and the fourth electrode CE4 of the boost capacitor Cbt are connected.

In an embodiment, FIG. 2B shows the third and fourth transistors T3 and T4 being NMOS and the first, second, and fifth to seven transistors T1, T2, T5, T6, and T7 being PMOS. The first transistor T1 directly affecting the brightness of the display device displaying an image may include a semiconductor layer including polysilicon having high reliability, and thus a high-resolution display device may be realized.

FIG. 2B explains that some transistors are NMOS and the others are PMOS, but embodiments are not limited thereto. In other embodiments, the sub-pixel circuit PC may include three transistors, and the three transistors may all be changed in various ways, such as all three transistors being NMOS.

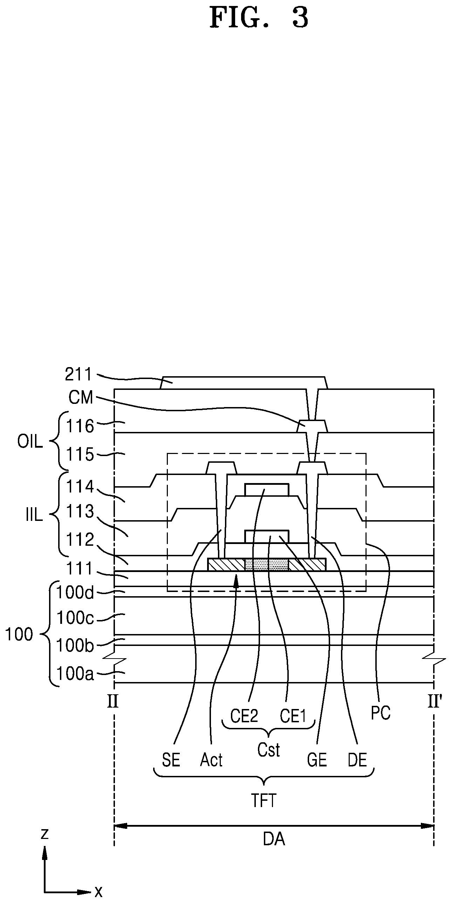

FIG. 3 is a schematic cross-sectional view of a display panel 10 according to an embodiment.

Referring to FIG. 3, a display panel 10 may include a substrate 100, an inorganic insulating layer IIL, an organic insulating layer OIL, a sub-pixel circuit PC, a connection electrode CM, and a pixel electrode 211. For example, the substrate 100, the inorganic insulating layer IIL, the organic insulating layer OIL, the sub-pixel circuit PC, the connection electrode CM, an organic light-emitting diode OLED, a pixel-defining layer 118, a spacer 119, and a thin-film encapsulation layer 300 may be arranged in the display area DA of the display panel 10.

The substrate 100 may include a first base layer 100a, a first barrier layer 100b, a second base layer 100c, and a second barrier layer 100d. In an embodiment, the first base layer 100a, the first barrier layer 100b, the second base layer 100c, and the second barrier layer 100d may be sequentially stacked in a thickness direction of the substrate 100.

At least one of the first base layer 100a and the second base layer 100c may include a polymer resin such as polyethersulfone, polyarylate, polyetherimide, polyethylene naphthalate, polyethylene terephthalate, polyphenylene sulfide, polyimide, polycarbonate, cellulose triacetate, or cellulose acetate propionate.

The first barrier layer 100b and the second barrier layer 100d, which are a barrier layers that prevent the penetration of the external foreign substances, may be a single layer or multiple layers including inorganic materials such as silicon nitride (SiNx), silicon oxide (SiO₂), and/or silicon oxynitride (SiON).

The buffer layer 111 may be disposed on the substrate 100. The buffer layer 111 may include an inorganic insulating material such as SiNx, SiON, and silicon oxide SiO₂, and may be a single layer or multiple layers including the inorganic insulating material.

The inorganic insulating layer IlL may be disposed on the buffer layer 111. The inorganic insulating layer IIL may include a first inorganic insulating layer 112, a second inorganic insulating layer 113, and a third inorganic insulating layer 114.

A sub-pixel circuit PC may be arranged in the display area DA. The sub-pixel circuit PC may include a thin-film transistor TFT and the storage capacitor Cst. The thin-film transistor TFT may include a semiconductor layer Act, a gate electrode GE, a source electrode SE, and a drain electrode DE.

The semiconductor layer Act may be disposed on the buffer layer 111. The semiconductor layer Act may include polysilicon. In another example, the semiconductor layer Act may include amorphous silicon, oxide semiconductor, or organic semiconductor. The semiconductor layer Act may include a channel area, and a drain area and a source area, which are on sides (e.g., opposite sides) of the channel area, respectively.

The gate electrode GE may be disposed on the semiconductor layer Act. The gate electrode GE may overlap the channel area. The gate electrode GE may include a low-resistance metal material. The gate electrode GE may include a conductive material including molybdenum (Mo), aluminium (Al), copper (Cu), titanium (Ti), etc., and may have a multi-layer structure or a single-layer structure including the conductive material.

The first inorganic insulating layer 112 may be arranged between the semiconductor layer Act and the gate electrode GE. The first inorganic insulating layer 112 may include an inorganic insulating material, such as SiO₂, SiNx, SiON, aluminium oxide (Al₂O₃), titanium oxide (TiO₂), tantalum oxide (Ta₂O₅), hafnium oxide (HfO₂), or zinc oxide (ZnO).

The second inorganic insulating layer 113 may be disposed on the gate electrode GE. The second inorganic insulating layer 113 may be provided to cover the gate electrode GE. The second inorganic insulating layer 113 may include an inorganic insulating material, such as SiO₂, SiNx, SiON, Al₂O₃, TiO₂, Ta₂O₅, HfO₂, or ZnO.

The upper electrode CE2 of the storage capacitor Cst may be disposed on the second inorganic insulating layer 113. The upper electrode CE2 may overlap the gate electrode GE thereunder. For example, the gate electrode GE and the upper electrode CE2 that overlap each other with the second inorganic insulating layer 113 therebetween may form the storage capacitor Cst. For example, the gate electrode GE may function as the lower electrode CE1 of the storage capacitor Cst.

As such, the storage capacitor Cst and the thin-film transistor TFT may overlap each other. However, one or more embodiments are not limited thereto. For example, the storage capacitor Cst may not overlap the thin-film transistor TFT. For example, the lower electrode CE1 of the storage capacitor Cst, which is a separate element from the gate electrode GE of the thin-film transistor TFT, may be spaced apart from the gate electrode GE of the thin-film transistor TFT.

The upper electrode CE2 may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu) and may have a single-layer structure or a multi-layer structure including the above-described material.

The third inorganic insulating layer 114 may be disposed on the upper electrode CE2. The third inorganic insulating layer 114 may cover the upper electrode CE2. The third inorganic insulating layer 114 may include SiO₂, SiNx, SiON, Al₂O₃, TiO₂, Ta₂O₅, HfO₂, or ZnO. The third inorganic insulating layer 114 may be a single layer or multiple layers including the inorganic insulating material.

The drain electrode DE and the source electrode SE may each be positioned on the third inorganic insulating layer 114. The drain electrode DE and the source electrode SE may each be connected to the semiconductor layer Act via contact holes provided/formed in the first inorganic insulating layer 112, the second inorganic insulating layer 113, and the third inorganic insulating layer 114. The drain electrode DE and the source electrode SE may include materials having good conductivity. The drain electrode DE and the source electrode SE may include conductive materials including Mo, Al, Cu, and Ti, and may have a multi-layer structure or a single-layer structure including the above-described materials. In an embodiment, the drain electrode DE and the source electrode SE may have a multi-layer structure of Ti/Al/Ti.

The organic insulating layer OIL may be disposed on the inorganic insulating layer IIL. The organic insulating layer OIL may include a first organic insulating layer 115 and a second organic insulating layer 116. FIG. 3 shows two organic insulating layers OIL, but embodiments are not limited thereto. The number of the organic insulating layers OIL may be one, three, or four.

A first organic insulating layer 115 may cover the drain electrode DE and the source electrode SE. The first organic insulating layer 115 may include an organic insulating material such as general-purpose polymer such as polymethylmethacrylate (PMMA) or polystyrene (PS), a polymer derivative having a phenol-based group, acryl-based polymer, imide-based polymer, aryl ether-based polymer, amide-based polymer, fluorine-based polymer, p-xylene-based polymer, vinyl alcohol-based polymer, and a blend thereof.

The connection electrode CM may be disposed on the first organic insulating layer 115. For example, the connection electrode CM may be connected to the drain electrode DE or source electrode SE via a contact hole of the first organic insulating layer 115. The connection electrode CM may contain a material with good conductivity. The connection electrode CM may include a conductive material including Mo, Al, Cu, Ti, etc., and may have a multi-layer structure or a single-layer structure including the conductive material. For example, the connection electrode CM may have a multi-layer structure of Ti/Al/Ti.

The second organic insulating layer 116 may be disposed on the connection electrode CM. The second organic insulating layer 116 may cover the connection electrode CM. The second organic insulating layer 116 and the first organic insulating layer 115 may be formed of the same material, or may be formed of different materials.

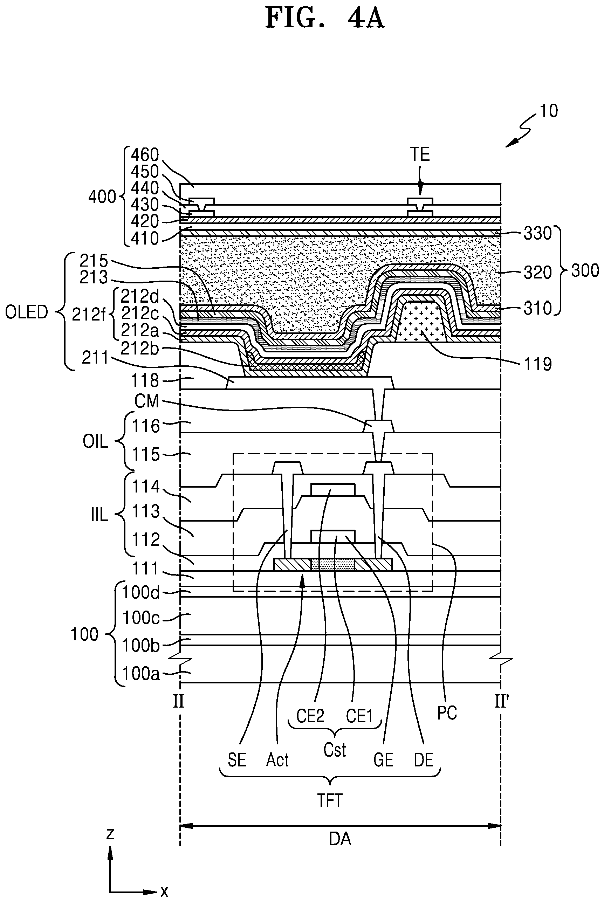

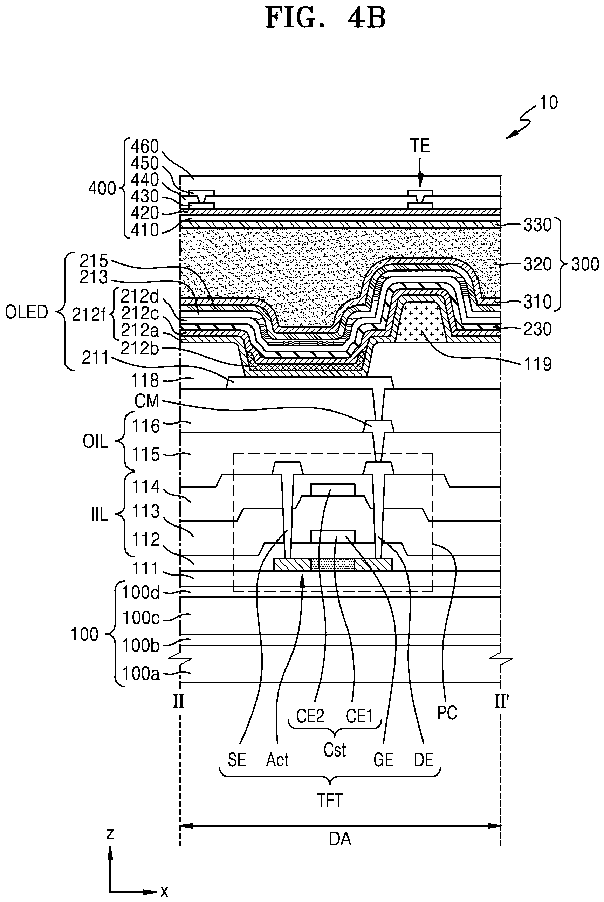

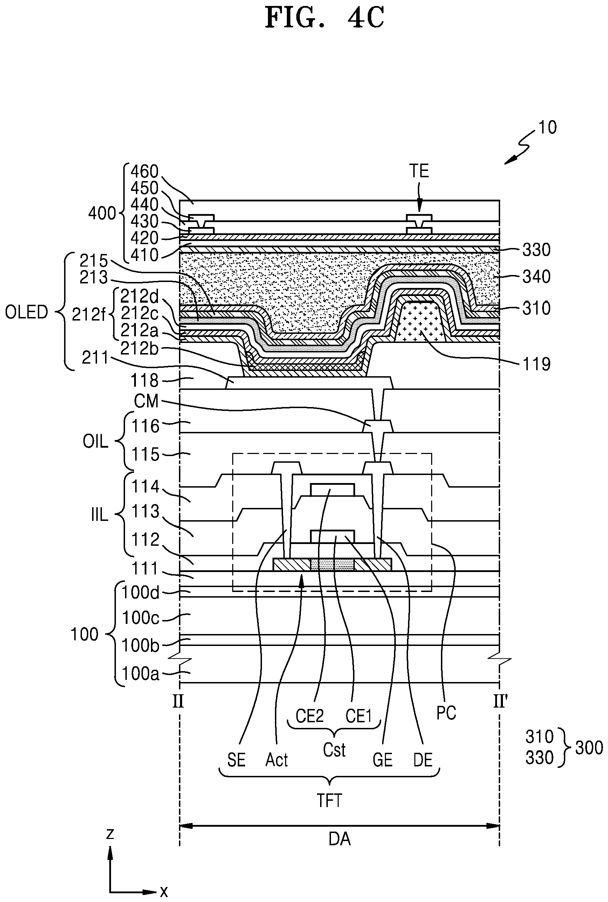

FIGS. 4A, 4B, and 4C are schematic cross-sectional views of a display panel 10 according to embodiments. FIGS. 4A to 4C show an organic light-emitting diode OLED including a pixel electrode 211, a thin-film encapsulation layer 300, and a touch sensor layer 400.

Referring to FIG. 4A, a light-emitting diode may be disposed on the second organic insulating layer 116. For example, the organic light-emitting diode OLED may be disposed on the second organic insulating layer 116. For example, an inorganic light-emitting diode may be disposed on the second organic insulating layer 116.

The organic light-emitting diode OLED may emit red light, green light, or blue light, or emit red light, green light, blue light, or white light. The organic light-emitting diode OLED may include the pixel electrode 211, an emission layer 212b, a functional layer 212f, a counter electrode 213, and a capping layer 215.

The pixel electrode 211 may be disposed on the second organic insulating layer 116. The pixel electrode 211 may be electrically connected to the connection electrode CM via the contact hole of the second organic insulating layer 116. The pixel electrode 211 may include a conductive oxide such as indium tin oxide (ITO), indium zinc oxide (IZO), zinc oxide (ZnO), indium oxide (In₂O₃), indium gallium oxide (IGO), or aluminium zinc oxide (AZO). In an embodiment, the pixel electrode 211 may include a reflective layer including Ag, Mg, Al, Pt, Pd, Au, Ni, Nd, Ir, Cr, or a compound thereof. In an embodiment, the pixel electrode 211 may further include a layer formed of ITO, IZO, ZnO, or In₂O₃ over/under the reflective layer. For example, the pixel electrode 211 may have a multi-layered structure of ITO/Ag/ITO.

An emission area of light emitted from the organic light-emitting diode OLED may be defined by an opening on the pixel electrode 211, the opening exposing at least a portion of the pixel electrode 211. For example, the width of the opening may correspond to the width of the emission area.

The pixel-defining layer 118 may include an organic insulating material. In another example, the pixel-defining layer 118 may include an inorganic insulating material such as SiNx, SiON, or SiO₂. In another example, the pixel-defining layer 118 may include an organic insulating material and an inorganic insulating material. In an embodiment, the pixel-defining layer 118 may include a light blocking material. The light blocking material may include carbon black, carbon nanotubes, a resin or a paste including black dye, metal particles, for example, Ni, Al, Mo, and an alloy thereof, metal oxide particles (e.g., chromium oxide, etc.), or metal nitride particles (e.g., chromium nitride, etc.). In the case that the pixel-defining layer 118 includes a light blocking material, the reflection of external light due to metal structures under the pixel-defining layer 118 may be reduced.

The spacer 119 may be arranged above the pixel-defining layer 118. The spacer 119 may include an organic insulating material such as polyimide. In another example, the spacer 119 may include an inorganic insulating material such as SiNₓ or SiO₂, or may include an organic insulating material and an inorganic insulating material.

In an embodiment, the spacer 119 and the pixel-defining layer 118 may include the same material. For example, the pixel-defining layer 118 and the spacer 119 may be formed together in a mask process by using a half-tone mask or the like. In another example, the spacer 119 and the pixel-defining layer 118 may include different materials.

The emission layer 212b may be arranged in the opening of the pixel-defining layer 118. The emission layer 212b may include a polymer or a low molecular weight organic material that emits light of a certain color.

The functional layer 212f may include a first functional layer 212a, a second functional layer 212c, and a common layer 212d. The first functional layer 212a may be arranged between the pixel electrode 211 and the emission layer 212b, and the second functional layer 212c may be arranged between the emission layer 212b and the common layer 212d. The common layer 212d may be arranged between the second functional layer 212c and the counter electrode 213. In another example, at least one of the first functional layer 212a, the second functional layer 212c, or the common layer 212d may be omitted. Hereinafter, cases in which the first functional layer 212a, the second functional layer 212c, and the common layer 212d are each provided will be described in detail.

The first functional layer 212a may include a hole transport layer (HTL) and/or a hole injection layer (HIL). The second functional layer 212c may include an electron transport layer (ETL). The common layer 212d may include an electron injection layer (EIL). The first functional layer 212a, the second functional layer 212c, and/or the common layer 212d may cover (e.g., entirely cover) the substrate 100 like the counter electrode 213 to be described below.

Referring to FIG. 4B, in an embodiment, a first buffer layer 230 may be arranged between the second functional layer 212c and the common layer 212d. The first buffer layer 230 may be arranged between the second functional layer 212c and the common layer 212d to prevent the material of the second functional layer 212c and the material of the common layer 212d from being mixed. The first buffer layer 230 may include metal oxide or metal halide. For example, the first buffer layer 230 may include ITO, IZO, aluminium doped zinc oxide, metal nanowire, or graphene. However, one or more embodiments are not limited thereto.

In an embodiment, a second buffer layer may be arranged between the counter electrode 213 and the capping layer 215. The second buffer layer may be arranged between the counter electrode 213 and the capping layer 215 to prevent the material of the counter electrode 213 and the material of the capping layer 215 from being mixed. The second buffer layer may include metal oxide or metal halide. For example, the second buffer layer may include metal oxide or metal halide. For example, the first buffer layer 230 may include ITO, IZO, aluminium doped zinc oxide, metal nanowire, or graphene. However, one or more embodiments are not limited thereto.

The counter electrode 213 may be disposed on the second functional layer 212c. The counter electrode 213 may include a conductive material having a low work function. For example, the counter electrode 213 may include a semi-transparent layer (or a transparent layer) including Ag, Mg, Al, Pt, Pd, Au, Ni, Nd, Ir, Cr, lithium (Li), Ca, or an alloy thereof. In another example, the counter electrode 213 may further include a layer such as ITO, IZO, ZnO, or In₂O₃ on the semi-transparent layer (or the transparent layer) including the above-described material.

In an embodiment, the capping layer 215 may be disposed on the counter electrode 213. The capping layer 215 may include lithium fluoride (LiF), an inorganic material, or/and an organic material.

The thin-film encapsulation layer 300 may be disposed on the organic light-emitting diode OLED. The thin-film encapsulation layer 300 may cover the organic light-emitting diode OLED. The thin-film encapsulation layer 300 may be disposed on the counter electrode 213 and/or the capping layer 215. In an embodiment, the thin-film encapsulation layer 300 may include at least one inorganic layer and at least one organic layer.

Referring to FIGS. 4A and 4B, in an embodiment, the thin-film encapsulation layer 300 may include a first inorganic encapsulation layer 310, an organic encapsulation layer 320, and a second inorganic encapsulation layer 330, which are sequentially stacked. The first and second inorganic encapsulation layers 310 and 330 may include at least one inorganic material among Al₂O₃, TiO₂, Ta₂O₅, HfO₂, ZnO, SiO₂, SiNx, and SiON. The first and second inorganic encapsulation layers 310 and 330 may be a single layer or multiple layers including the above-described materials. The organic encapsulation layer 320 may include a polymer-based material. The polymer-based material may include an acryl-based resin, an epoxy-based resin, polyimide, and polyethylene. In an embodiment, the organic encapsulation layer 320 may include acrylate. The thickness of the thin-film encapsulation layer 300 may be reduced for the implementation of the low curvature of the display device 1. For example, the thickness of the organic encapsulation layer 320 may be equal to or less than about 8 µm.

Referring to FIG. 4C, in an embodiment, the thin-film encapsulation layer 300 may include the first inorganic encapsulation layer 310 and the second inorganic encapsulation layer 330. The thickness of the thin-film encapsulation layer 300 may be reduced for the implementation of the low curvature of the display device 1. The organic encapsulation layer 320 may be omitted to reduce the thickness of the thin-film encapsulation layer 300 of the display device 1. For example, the thin-film encapsulation layer 300 may not include the organic encapsulation layer 320. Instead of the organic encapsulation layer 320, a composite material layer 340 may be arranged between the first inorganic encapsulation layer 310 and the second inorganic encapsulation layer 330. The composite material layer 340 may planarize the display panel 10. The first and second inorganic encapsulation layers 310 and 330 may include at least one inorganic material among Al₂O₃, TiO₂, Ta₂O₅, HfO₂, ZnO, SiO₂, SiNx, and SiON. The composite material layer 340 may include a material in which an inorganic material of the first and second inorganic encapsulation layers 310 and 330 and a polymer-based organic material are mixed. The polymer-based material may include an acryl-based resin, an epoxy-based resin, polyimide, and polyethylene.

The touch sensor layer 400 may be disposed on the thin-film encapsulation layer 300. The touch sensor layer 400 may include a first touch insulating layer 410, a second touch insulating layer 420, a first conductive layer 430, a third touch insulating layer 440, a second conductive layer 450, and a planarization layer 460.

In an embodiment, the first touch insulating layer 410 may be disposed on the second inorganic encapsulation layer 330, and the second touch insulating layer 420 may be disposed on the first touch insulating layer 410. In an embodiment, the first and second touch insulating layers 410 and 420 may include an inorganic insulating material and/or an organic insulating material. For example, the first and second touch insulating layers 410 and 420 may include an inorganic insulating material such as SiO₂, SiNx, and/or SiON.

In another example, at least one of the first and second touch insulating layers 410 and 420 may be omitted. For example, the first touch insulating layer 410 may be omitted. In an embodiment, the second touch insulating layer 420 may be disposed on the second inorganic encapsulation layer 330, and the first conductive layer 430 may be disposed on the second touch insulating layer 420.

The first conductive layer 430 may be disposed on the second touch insulating layer 420, and the third touch insulating layer 440 may be disposed on the first conductive layer 430. In an embodiment, the third touch insulating layer 440 may include an inorganic insulating material and/or an organic insulating material. For example, the third touch insulating layer 440 may include an inorganic insulating material such as SiO₂, SiNx, and/or SiON.

The second conductive layer 450 may be disposed on the third touch insulating layer 440. A touch electrode TE may have a structure in which the first conductive layer 430 and the second conductive layer 450 are connected. In another example, the touch electrode TE may be formed on one of the first conductive layer 430 and the second conductive layer 450 and may include a metal line provided in the corresponding conductive layer. The first and second conductive layers 430 and 450 may each include at least one of Al, Cu, Ti, MO, and ITO, and may each be a single layer or multiple layers including the above-described materials. For example, the first conductive layer 430 and the second conductive layer 450 may each have a three-layer structure of a Ti/Al/Ti.

In an embodiment, the planarization layer 460 may cover the second conductive layer 450. The planarization layer 460 may include an organic insulating material.

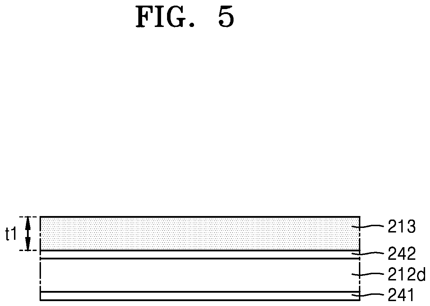

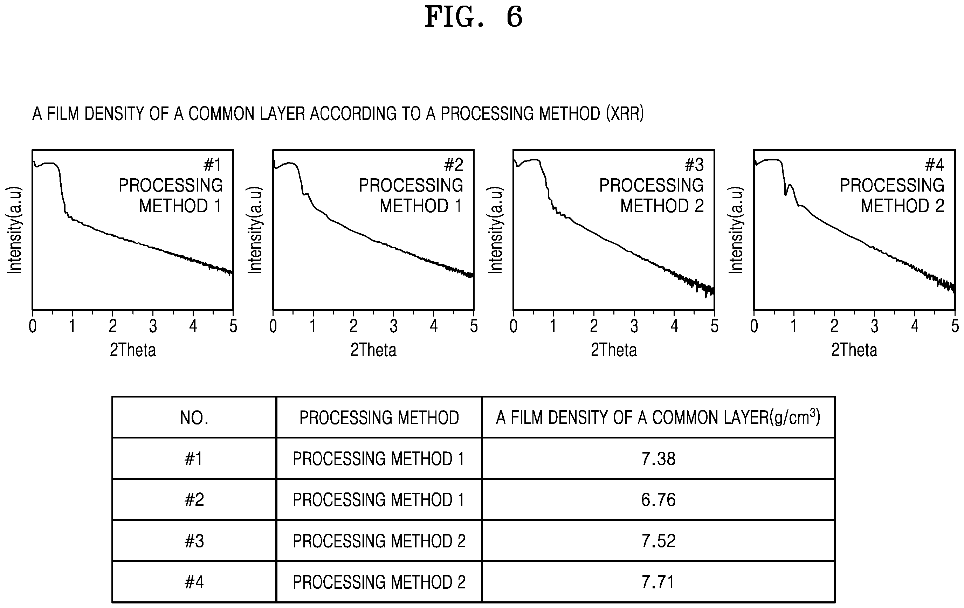

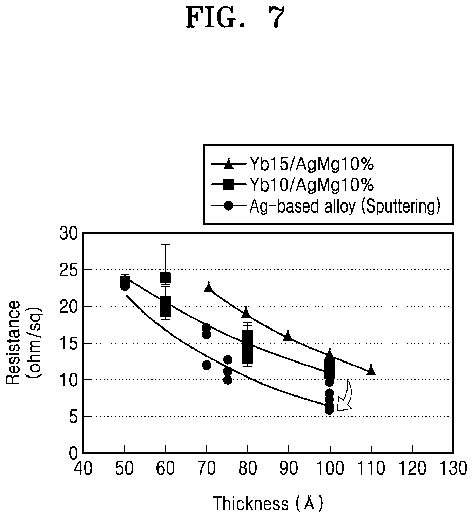

FIG. 5 is a schematic cross-sectional view of an enlarged portion of a display panel 10 according to an embodiment. FIG. 6 is a schematic graph showing X-ray reflectometry (XRR) analysis results according to a processing method. FIG. 7 is a schematic graph showing a resistance according to the thickness of each material of a counter electrode. FIG. 5 is a schematic cross-sectional view illustrating an enlargement of the cross-sectional view of a display panel 10 in which the common layer 212d and the counter electrode 213 are arranged.

The display panel 10 may include the first organic insulating layer 115 and/or the second organic insulating layer 116 as described above. A contact hole may be formed in the first organic insulating layer 115 and/or the second organic insulating layer 116. Because the contact hole needs to be formed in the first organic insulating layer 115 and/or the second organic insulating layer 116, the first organic insulating layer 115 and/or the second organic insulating layer 116 may include polyimide (PI) (e.g., a photo sensitive polyimide (PSPI)) which is patterned. Gas may be generated in the process of manufacturing the first organic insulating layer 115 and/or the second organic insulating layer 116 including PI. Gas may be emitted in the process of manufacturing the first organic insulating layer 115 and/or the second organic insulating layer 116 including PI. In the case that the display panel 10 includes both the first and second organic insulating layers 115 and 116 such that the organic insulating layer OIL has a double structure, the amount of gas generated in the organic insulating layer OIL may be increased. Because of the gas generated in the first organic insulating layer 115 and/or the second organic insulating layer 116, the common layer 212d and/or counter electrode 213 formed of a metal may be oxidized, and pixel shrinkage may occur in the display device 1.

In an embodiment, the common layer 212d may include an electron injection layer (EIL). The common layer 212d may include ytterbium (Yb), which has excellent electron injection properties. Although ytterbium (Yb) has excellent electron injection properties, ytterbium (Yb) may not be formed thickly because of its high light absorption properties. Because the common layer 212d may not be formed thickly, in the case that a film density of the common layer 212d is increased to improve the film density and thickness, oxidation of the common layer 212d due to gas generated in the organic insulating layer OIL may be prevented and pixel shrinkage of the display device 1 may be inhibited/prevented. The film density of the common layer 212d is in a range of about 3 g/cm³ to about 10 g/cm³. The film density of the common layer 212d may need to be in a range of about 3 g/cm³ to about 10 g/cm³ to prevent oxidation of the common layer 212d due to gas generated in the organic insulating layer OIL. In the case that the film density of the common layer 212d is less than about 3 g/cm³, the common layer 212d may be oxidized due to the gas generated in the organic insulating layer OIL of the display panel 10, and pixel shrinkage of the display device 1 may occur. In the case that the film density of the common layer 212d exceeds about 10 g/cm³, the efficiency in the manufacturing process of the display panel 10 may be decreased and the cost may be increased. In another example, the film density of the common layer 212d may be in a range of about 5 g/cm³ to about 10 g/cm³. The film density of the common layer 212d may need to be in a range of about 5 g/cm³ to about 10 g/cm³ to prevent oxidation of the common layer 212d due to gas generated in the organic insulating layer OIL. In the case that the film density of the common layer 212d is less than about 5 g/cm³, the common layer 212d may be oxidized due to the gas generated in the organic insulating layer OIL of the display panel 10, and pixel shrinkage of the display device 1 may occur. In the case that the film density of the common layer 212d exceeds about 10 g/cm³, the efficiency in the manufacturing process of the display panel 10 may be decreased and the cost may be increased. In another example, the film density of the common layer 212d may be in a range of about 7 g/cm³ to about 10 g/cm³. The film density of the common layer 212d may need to be in a range of about 7 g/cm³ to about 10 g/cm³ to prevent oxidation of the common layer 212d due to gas generated in the organic insulating layer OIL. In the case that the film density of the common layer 212d is less than about 7 g/cm³, the common layer 212d may be oxidized due to the gas generated in the organic insulating layer OIL of the display panel 10, and pixel shrinkage of the display device 1 may occur. In the case that the film density of the common layer 212d exceeds about 10 g/cm³, the efficiency in the manufacturing process of the display panel 10 may be decreased and the cost may be increased.

In an embodiment, the common layer 212d may include oxygen (O). In another example, the common layer 212d may include a Yb-O bond. In the case that the common layer 212d includes oxygen (O) or a Yb-O bond, the oxygen (O) of the common layer 212d may inhibit/prevent the oxidation of the common layer 212d due to gas generated in the organic insulating layer OIL.

FIG. 6 shows the film density of the common layer 212d as a result of X-ray reflectometry (XRR) analysis according to processing methods 1 or 2. Processing method 1 may be a heat deposition method. In the case that processing method 1 is used, the film density of the common layer 212d may be about 7.38 g/cm³ or about 6.76 g/cm³. Processing method 2 may be a sputtering method. In the case that processing method 2 is used, the film density of the common layer 212d may be about 7.52 g/cm³ or about 7.71 g/cm³. Because the film density of the common layer 212d is improved in the case that processing method 2 is used, the common layer 212d may be formed by processing method 2.

In the case that the sputtering method is used, a greater number of Yb-O bonds may be included in the common layer 212d as compared to the case that the heat deposition method is used. In the case that the sputtering method is used, a greater amount of oxygen (O) may be included in the common layer 212d as compared to the case that the heat deposition method is used. To increase the concentration of Yb-O bonds or oxygen (O) in the common layer 212d, the common layer 212d may be formed by the sputtering method.

For the high resolution or high-speed driving of the display device 1, the radius of the curvature of the foldable or flexible display device 1 may be reduced. In order to reduce the radius of the curvature of the display device 1, the thickness of the organic encapsulation layer 320 included in the thin-film encapsulation layer 300 may be reduced. By reducing the thickness of the thin-film encapsulation layer 300, mutual interference between the touch sensor layer 400 and the substrate 100may cause noise, which adversely affects the sensitivity of the touch sensor layer 400. To improve the sensitivity of the touch sensor layer 400 and reduce the noise caused by the mutual interference between the touch sensor layer 400 and the substrate 100, the counter electrode 213 may have a low resistance. In the case that the counter electrode 213 has a low resistance, the noise between the touch sensor layer 400 and the substrate 100 may be reduced, thereby improving the sensitivity of the touch sensor layer 400.

FIG. 7 schematically shows resistances according to the thickness of each material of the counter electrode 213. In the case that the counter electrode 213 includes an Ag-based alloy, the counter electrode 213 may, according to the thickness, have a lower resistance than that of an alloy including about 10% Ag and Mg. In the case that the counter electrode 213 includes an Ag-based alloy, the counter electrode 213 may have a low resistance.

The counter electrode 213 may include an Ag-based alloy. The Ag-based alloy of the counter electrode 213 may include Ag at a concentration ranging from about 95% to about 100%. The Ag-based alloy of the counter electrode 213 may include at least one selected from gold (Au), copper (Cu), magnesium (Mg), titanium (Ti), indium (In), nickel (Ni), carbon (C), palladium (Pd), fluorine (F), sodium (Na), silicon (Si), calcium (Ca), manganese (Mn), iron (Fe), cobalt (Co), zinc (Zn), gallium (Ga), germanium (Ge), molybdenum (Mo), tin (Sn), platinum (Pt), lead (Pb), ytterbium (Yb), lutetium (Lu), and protactinium (Pa).

In another example, the counter electrode 213 may include an Al-based alloy. The Al-based alloy of the counter electrode 213 may include Al at a concentration ranging from about 95% to about 100%. The Al-based alloy of the counter electrode 213 may include at least one selected from Au, Cu, Mg, Ti, In, Ni, C, Pd, F, Na, Si, Ca, Mn, Fe, Co, Zn, Ga, Ge, Mo, Sn, Pt, Pb, Yb, Lu, or Pa.

The counter electrode 213 may include oxygen (O). Due to the oxygen (O) of the counter electrode 213, the oxidation of the counter electrode 213 due to the gas generated in the organic insulating layer OIL disposed below the counter electrode 213 may be inhibited/prevented.

The thickness t1 of the counter electrode 213 may be in a range of about 5 nm to about 100 nm. Referring to FIG. 7, as the thickness t1 of the counter electrode 213 increases, the resistance of the counter electrode 213 may decrease. In the case that the counter electrode 213 is in a range of about 5 nm to about 100 nm, due to the low resistance of the counter electrode 213, the noise between the touch sensor layer 400 and the substrate 100 may be reduced, thereby improving the sensitivity of the touch sensor layer 400. In the case that the thickness t1 of the counter electrode 213 is less than about 5 nm, the resistance may be increased, and, due to the noise between the touch sensor layer 400 and the substrate 100, the sensitivity of the touch sensor layer 400 may be adversely affected. In the case that the thickness t1 of the counter electrode 213 is greater than about 100 nm, light transmittance may be decreased, and thus, visibility may be reduced. In another example, the thickness t1 of the counter electrode 213 may be in a range of about 5 nm to about 80 nm. In the case that the counter electrode 213 is in a range of about 5 nm to about 80 nm, due to the low resistance of the counter electrode 213, the noise between the touch sensor layer 400 and the substrate 100 may be reduced, thereby improving the sensitivity of the touch sensor layer 400. In another example, the thickness t1 of the counter electrode 213 may be in a range of about 5 nm to about 60 nm. In the case that the counter electrode 213 is in a range of about 5 nm to about 60 nm, due to the low resistance of the counter electrode 213, the noise between the touch sensor layer 400 and the substrate 100 may be reduced, thereby improving the sensitivity of the touch sensor layer 400. In the case that the thickness t1 of the counter electrode 213 is less than about 5 nm, the resistance may be increased, and, due to the noise between the touch sensor layer 400 and the substrate 100, the sensitivity of the touch sensor layer 400 may be adversely affected. In the case that the thickness t1 of the counter electrode 213 is about 60 nm or greater than or equal to about 80 nm, light transmittance may be decreased, and thus, visibility may be reduced.

The resistance of the counter electrode 213 may be in a range of about 1 ohm/sq to about 20 ohm/sq. In another example, the resistance of the counter electrode 213 may be in a range of about 1 ohm/sq to about 10 ohm/sq. In order to reduce the noise between the touch sensor layer 400 and the substrate 100 due to the reduced thickness of the thin-film encapsulation layer 300, the counter electrode 213 may have a low resistance. In the case that the resistance of the counter electrode 213 is in a range of about 1 ohm/sq to about 20 ohm/sq, due to the low resistance of the counter electrode 213, the noise between the touch sensor layer 400 and the substrate 100 may be reduced, thereby improving the sensitivity of the touch sensor layer 400. In the case that the resistance of the counter electrode 213 is less than about 1 ohm/sq, the efficiency in the processing of the display panel 10 may be reduced and the cost may be greatly increased.

In an embodiment, referring to FIG. 5, a first mixed layer 241 may be disposed under the common layer 212d. The first mixed layer 241 may be in contact with (e.g., in direct contact with) the lower portion of the common layer 212d. For example, the first mixed layer 241 may be arranged between the common layer 212d and the second functional layer 212c. The common layer 212d may include ytterbium (Yb) or oxygen (O). The second functional layer 212c may be an electron injection layer (EIL). The second functional layer 212c may include LiF, NaCl, CsF, Li₂O, or BaO. The first mixed layer 241 may be a layer in which a material of the common layer 212d and a material of the second functional layer 212c are mixed. The thickness of the first mixed layer 241 may be about 0.1 nm or more. However, one or more embodiments are not limited thereto.

For example, a second mixed layer 242 may be disposed on the upper part of the common layer 212d. The second mixed layer 242 may be in contact with (e.g., in direct contact with) the upper portion of the common layer 212d. For example, the second mixed layer 242 may be arranged between the common layer 212d and the counter electrode 213. The common layer 212d may include ytterbium (Yb) or oxygen (O). The counter electrode 213 may include a semi-transparent layer (or a transparent layer) including Ag, Mg, Al, Pt, Pd, Au, Ni, Nd, Ir, Cr, Li, Ca, or an alloy thereof. The second mixed layer 242 may be a layer in which a material of the common layer 212d and a material of the counter electrode 213 are mixed. The thickness of the second mixed layer 242 may be greater than or equal to about 0.1 nm. However, one or more embodiments are not limited thereto.

Gas is generated in the manufacturing process due to the material of the organic insulating layer included in the display device as a comparative example, which caused oxidation of the counter electrode and the common layer, thereby causing pixel shrinkage of the display device as a comparative example. For high resolution and high-speed driving of the display device, the radius of the curvature of the display device as a comparative example is reduced, resulting in the thickness of the thin-film encapsulation layer being reduced. Accordingly, a noise occurred between the touch sensor layer and the substrate 100, thereby adversely affecting the sensitivity of the touch sensor layer.

In the case that the common layer 212d of the display device 1 according to an embodiment is formed by the sputtering method, the film density of the common layer 212d may be improved. The common layer 212d of the display device 1 may include oxygen (O) or a Yb-O bond. Due to the improvement of film density and material of the common layer 212d, oxidation of the common layer 212d due to gas generated in the organic insulating layer OIL of the display panel 10 may be inhibited/prevented, thereby preventing pixel shrinkage of the display device 1.

The counter electrode 213 may include an Ag-based alloy or an Al-based alloy. The thickness t1 of the counter electrode 213 may be in a range of about 5 nm to about 100 nm. Due to the material and the thickness t1 of the counter electrode 213, the counter electrode 213 may have low resistance, and due to the counter electrode 213 having low resistance, the noise between the touch sensor layer 400 and the substrate 100 is inhibited/prevented, thereby improving the sensitivity of the touch sensor layer 400.

According to one or more embodiments, a display device having improved reliability and touch screen panel characteristics may be improved. However, the scope of the disclosure is not limited to these effects.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A display device comprising:
a substrate;
a pixel electrode disposed on the substrate;
a common layer disposed on the pixel electrode; and
a counter electrode disposed on the common layer, wherein
a film density of the common layer is in a range of about 3 g/cm³ to about 10 g/cm³.

2. The display device of claim 1, wherein the common layer comprises ytterbium (Yb).

3. The display device of claim 1 or claim 2, wherein the common layer comprises an ytterbium (Yb)-oxygen (O) bond.

4. The display device of any one of claims 1 to 3, wherein the counter electrode comprises a silver (Ag)-based alloy or an aluminium (Al)-based alloy.

5. The display device of claim 4, wherein the Ag-based alloy or the Al-based alloy of the counter electrode is formed of Ag or Al ranging from about 95% to about 100%.

6. The display device of claim 4 or claim 5, wherein the counter electrode comprises at least one selected from gold (Au), copper (Cu), magnesium (Mg), titanium (Ti), indium (In), nickel (Ni), carbon (C), palladium (Pd), fluorine (F), sodium (Na), silicon (Si), calcium (Ca), manganese (Mn), iron (Fe), cobalt (Co), zinc (Zn), gallium (Ga), germanium (Ge), molybdenum (Mo), tin (Sn), platinum (Pt), lead (Pb), ytterbium (Yb), lutetium (Lu), and protactinium (Pa).

7. The display device of any one of claims 1 to 6, wherein the counter electrode comprises oxygen (O).

8. The display device of any one of claims 1 to 7, wherein a thickness of the counter electrode is in a range of about 5 nm to about 100 nm.

9. The display device of any one of claims 1 to 8, wherein a resistance of the counter electrode is in a range of about 1 ohm/sq to about 20 ohm/sq.

10. The display device of any one of claims 1 to 9, further comprising:
a first functional layer disposed on the pixel electrode;
an emission layer disposed on the first functional layer; and
a second functional layer disposed on the emission layer, optionally further comprising:
a first mixed layer disposed between the second functional layer and the common layer.

11. The display device of any one of claims 1 to 10, further comprising:
a second mixed layer disposed between the common layer and the counter electrode.

12. The display device of any one of claims 1 to 11, further comprising:
a first buffer layer disposed under the common layer, optionally wherein the first buffer layer comprises metal oxide or metal halide.

13. The display device of any one of claims 1 to 12, further comprising:
a second buffer layer disposed on the counter electrode, optionally wherein the second buffer layer comprises metal oxide or metal halide.

14. The display device of any one of claims 1 to 13, further comprising:
a thin-film encapsulation layer disposed over the counter electrode, the thin-film encapsulation layer comprising:
a first inorganic encapsulation layer, and
a second inorganic encapsulation layer disposed on the first inorganic encapsulation layer; and
a touch sensor layer disposed on the thin-film encapsulation layer, the touch sensor layer comprising:
touch insulating layers, and
conductive layers, optionally wherein the thin-film encapsulation layer comprises an organic encapsulation layer disposed between the first inorganic encapsulation layer and the second inorganic encapsulation layer.

15. The display device of any one of claims 1 to 14, further comprising:
a first organic insulating layer disposed between the substrate and the pixel electrode, optionally further comprising:
a second organic insulating layer disposed between the substrate and the first organic insulating layer.
